Europäisches Patentamt

European Patent Office

Office européen des brevets

(11) Publication number: **0 137 165**
**B1**

(12) **EUROPEAN PATENT SPECIFICATION**

(45) Date of publication of patent specification: 01.06.88

(21) Application number: 84108920.4

(22) Date of filing: 27.07.84

(51) Int. Cl.⁴: **H 03 K 3/356,** H 03 K 3/037, G 01 R 31/28, G 06 F 11/26

(54) Optional single or double clocked latch.

(30) Priority: 01.08.83 US 519338

(43) Date of publication of application:
17.04.85 Bulletin 85/16

(45) Publication of the grant of the patent:
01.06.88 Bulletin 88/22

(84) Designated Contracting States:
DE FR GB

(56) References cited:
US-A-3 993 919
US-A-4 004 170

(73) Proprietor: International Business Machines Corporation
Old Orchard Road
Armonk, N.Y. 10504 (US)

(72) Inventor: Kiley, Donald Burns
Bacon Drive
Shelburne Vermont 05482 (US)

(74) Representative: Mönig, Anton, Dipl.-Ing.
IBM Deutschland GmbH Schönaicher Strasse 220
D-7030 Böblingen (DE)

Courier Press, Leamington Spa, England.

Description

The invention relates generally to logic circuits employing shift registers and more particularly to logic circuits which require double clocking latches during testing of the circuits and single clocking latches when the circuits are operating in their non-test or function mode.

Microprocessors, which employ a large number of latching circuits, require both master and slave latching circuits with a plurality of clocks arranged such that the shift registers can be latched during the testing mode, but operated as an unlatched register during the normal or function operation mode. In the prior art this is accomplished by using master and slave circuits coupled in series. Such complex circuits can not use common tests as stuck fault testing.

Typical prior art is the following:

U.S. Patent 4,004,170 describes a MOSFET latching circuit which employs a bi-stable latch that is arranged such that one side drives an enhancement mode device while the other side drives a depletion mode device connected in push-pull arrangement.

U.S. Patent 3,993,919 describes a programmable latch for logic array which uses three different metallization patterns to provide three different latches. By adding a device and changing selected interconnections a J-K flip-flop can be converted into an AND polarity hold and a gated polarity hold circuit.

The invention as claimed solves the problem of how to devise a programmable latching circuit which can serve as either a single or double clocked latch which can be operated to capture and hold output data during operation mode with stable data inputs while being operable as a double clocked shift register latch during the test mode, thus preventing race or flush in the scan rings in the test mode from occuring.

The present invention thus provides a simple circuit that will meet the level sensor scan design for automatic generation of stuck fault test while providing a simple circuit which will reduce logic delay. If desired, a third clock, which is optional, can be used to provide the scan features to set internal test points and read internal logic points on the circuit.

The invention will become more apparent when taken in conjunction with the following descriptions and drawings wherein there is set forth a specific embodiment of the present invention.

Fig. 1 illustrates in block form a complete register embodying the present invention.

Fig. 2 illustrates in schematic form the register of Fig. 1.

Register stacks are intrinsic to selected microprocessors some of which require outputs of 15 high speed registers at local storage. Each of these registers is required to be at least 32 bits long and made even longer if parity is required for the 32 bit processor. Such registers that are necessary and provide internal logic during the operation mode must be tested. However, during the test mode they must be treated as if they were shift register latches. As is well known shift register latches require two clocks to scan data into and out of the shift register scan rings in order to prevent race or flush of the scan rings. However, during operation mode two clocks are not-needed and indeed may be detrimental to the power or speed characteristics of the register. Only a single clock is necessary to capture and hold the output data during the operation mode.

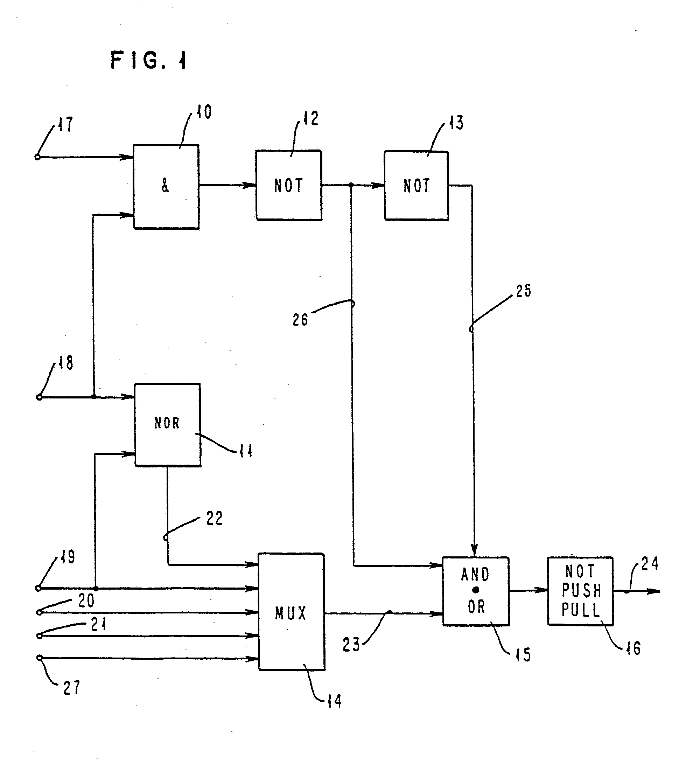

Turning now to the figures, a register circuit built in accordance with the present invention will be described in great detail as to its construction and operation. In Fig. 1 there is shown a block diagram of the apparatus illustrating the logic of the invention. This comprises an AND circuit 10, a NOR circuit 11, a pair of serial NOT circuits 12 and 13, a multiplexer 14, and an AND/OR circuit 15 in series with a NOT pushpull circuit 16. A first clock pulse is coupled into the AND circuit 10 via node 17. An input is also fed into this AND circuit via node 18 which also leads to NOR circuit 11. Also feeding into the NOR circuit 11 is a second clock pulse via node 19, this node 19 feeds the multiplexer 14 together with a data input signal on node 20 and a scan input signal node 21. Whenever the input pulse on node 18 is low the entire circuit shown operates in a single clock mode and any signal that appears upon node 17 remains invalid since it must be ANDED with a high input on node 18 to produce an output feeding to the serial NOT circuits 12 and 13 and hence to the AND/OR circuit 15. Thus, the only clock pulse which is effective, when the input 18 is low, is the clock pulse appearing upon the node 19 which is coupled into the NOR circuit 11 and into the multiplexer 14. When this node 19 rises the NOR circuit 11 becomes active and transmits a signal via line 22, to the multiplexer circuit 14. When this occurs the multiplexer 14 is able to receive information via either the data line 20 or the scan line 21. Information so fed into the multiplexer is passed, via line 23, into the AND/OR circuit 15 to activate the NOT push-pull circuit 16 and provide a suitable output on the output line 24. Conversely when node 18 is high the circuit operates in a double clock mode. In this case operation of the circuit depends on coincidence of positive signals from both the first clock on node 17, the input 18 and the second clock 19. When node 18 is high and positive clock pulse appearing on node 17 becomes effective to activate the AND circuit 10 which then provides an output to the serial NOT circuits 12 and 13. This activity causes suitable pulses to appear on lines 25 and 26 leading to the AND/OR circuit 15 and causes the NOT push-pull circuit 16 to provide a suitable data output on line 24.

Simultaneously, because the NOR circuit 11 is active and line 22 is low, the multiplexer circuit 14 is rendered inactive and neither data or scan pulses are permitted to be transferred from either node 20 or 21 through the multiplexer 14.

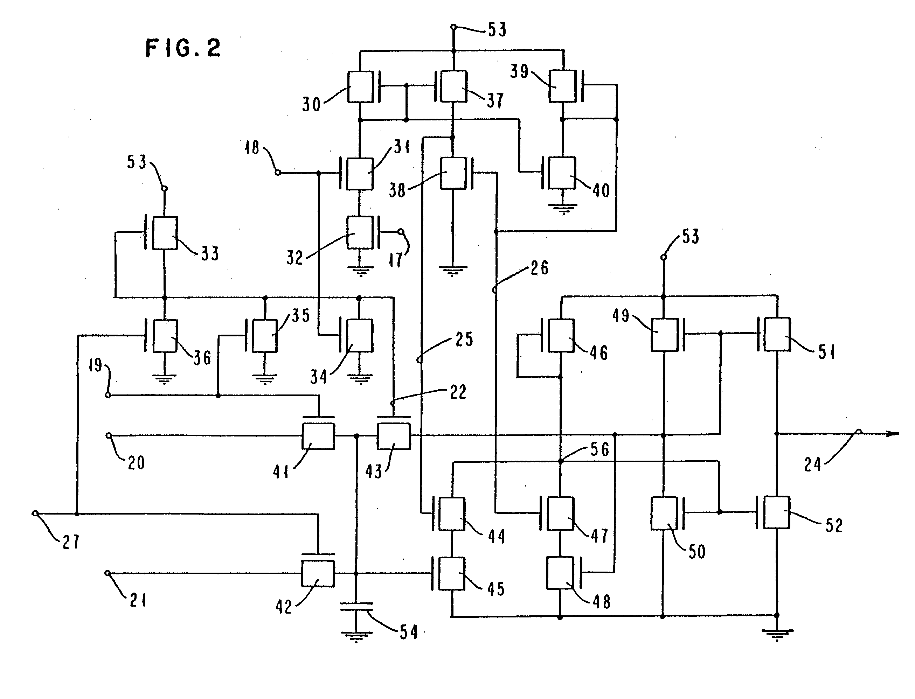

Fig. 2 shows in great schematic detail the devices and the arrangements of the circuit of Fig.

1. In this circuit transistors 30, 31, and 32 comprise AND circuit 10 while devices 33, 34, 35, and 36 comprise the NOR circuit 11. Devices 37 and 38 comprises NOT circuit 13, devices 39 and 40 comprises NOT circuit 12, transistors 41, 42, and 43 comprises a multiplexer circuit 14 while transistors 44, 45, 46, 47, and 48 comprise the AND/OR circuit 15 and devices 49, 50, 51, and 52 comprise the NOT push-pull circuit 16.

The AND circuit 10 comprises a load transistor 30, and two input transistors 31, and 32 arranged in series. The load transistor 30 has its source coupled to a voltage source 53 and its drain coupled through input transistors 31 and 32 to ground and also coupled to its own gate or control electrode and the gate of load transistor 37 and the gate of source follower transistor 40. Transistor 31 has its gate coupled to the node 18 and the gate of transistor 34 in the NOR circuit 11, while the gate of transistor 32 has its gate coupled to node 17. In the NOR circuit 11, comprised of transistors 33, 34, 35, and 36, transistor 33 is a load transistor having its source coupled to voltage source 53 while its drain is coupled to its own gate, to the line 22 and to the source of parallel decode transistors 34, 35, and 36 whose drains are all coupled to ground. Because it is desirable to permit only a scan or a data pulse into the latch of the invention an additional clocking node 27 is provided. This node 27 controls the data input transistor 42 while node 19 controls the scan input transistor 41. The gate of transistor 35 is coupled to the node 19 while the gate of transistor 36 is coupled to the node 27. The NOT circuits 12 and 13 comprises load transistors 37 and 39 and inverter transistors 38 and 40. In particular in circuit 13 load transistor 37 has its source coupled to the voltage source 53 and its drain coupled through transistor 38 to ground and to the line 25. The NOT circuit 12 also comprises a load transistor 39 whose source is coupled to voltage source 53 and whose drain is coupled to its own gate transistor 38 and to line 26 and to ground through transistor 40 whose gate is coupled to the gate transistors 30 and 37.

The multiplexer 14 comprises transistors 41, 42, and 43. The source of transistor 41 is coupled to the data node 20 and its drain is coupled to the source of transistor 43, the capacitor 54 and the drain of transistor 42 whose source is coupled to the scan node 21. The gate of switching transistor 43 is coupled to the line 22.

The AND/OR circuit 15 consists of programming transistors 44 and 47, load 46 and gating transistors 45 and 48. Load transistor 46 has its source coupled to the voltage source 53 and its drain is coupled through both programming transistors 44 and 47 and through gating transistors 45 and 48 in series with the programming transistors to ground. The gate of transistor 44 is coupled to line 25 while the gate of transistor 47 is coupled to line 26. The gate of transistor 45 is coupled to capacitor 54, the drains of transistors 41 and 42 and through the switching of transistor 43 to the gate of transistor 48. It should be noted at this time that the capacitor 54 can be separate physical capacitor as shown or can be the gate capacitance of transistor 45 or a parasitic capacitance. The NOT pushpull circuit 16 consists of load transistor 49, an inverting source follower transistor 50, push transistor 51 and pull transistor 52. Transistors 49 and 51 both have their sources coupled to the voltage source 53. The drain of transistor 49 is coupled to the drain of switching transistor 43, the gate of gating transistor 48 and through the (inverting) switching transistor 50 to ground. Transistor 50 has its gate coupled to the drain of load transistor 46 and the sources of programming transistors 44 and 47. The source of push transistor 51 is coupled to the voltage source 53 and its drain coupled to the output line 24 and through pull transistor 52 to ground. The gate of pull transistor 52 is coupled to the gate of transistor 50, while the gate of transistor 51 coupled to the drain of load transistor 49.

Transistors 43 through 52 and the capacitance 54 form a double ended cross coupled programmable latch circuit having first and second programmable legs and a non-programmable leg with the first leg cross coupled to the third leg and the second leg switchably cross coupled to the third leg so that the second leg may be selectively removed from the circuit.

The above described logic circuit operates as follows. Initially the single clock mode will be described. It will be assumed that node 17 is normally on and that node 18 is low. With node 17 on transistor 32 is on however with node 18 off transistor 31 is off and thus no current flow occurs through either transistors 31 or 32, i.e., the AND circuit 10 is not active and the transistors 30, 37, and 40 are all on. When the node 18 is off transistor 34 is also off. With transistor 40 being on line 26 is held low and transistor 38 is also off. This causes line 25 to be high and transistor 44 to be on. With transistor 44 on if either of the nodes 19 or 27 go high then either data can be written in capacitor 54 via node 20 or scan information can be entered via node 21 depending upon what node 19 or 27 has gone high. If either of the nodes 19 or 27 rises, either transistors 35 or 36 turns on causing line 22 to be pulled low and turning off transistor 43. Thus data or scan information can now be applied via either node 20 or 21 through transistors 41 or 42 and charge the capacitor 54 positively so as to turn on transistor 45. When transistor 45 comes on current is now drawn through transistors 44 and 45, since line 25 is also high pulling node 56, i.e., the source of transistor 47, low. When node 56 goes low transistors 50 and 52 are held off and the gate of transistor 51 rises turning transistor 51 on and pushing the output line 24 toward the voltage source 53. When nodes 18 and 19 and 27 are all low the three transistors 34, 35, and 36 are all off and line 22 is high causing transistor 43 to turn on and set the base of transistors 51 and 48 at the level of the capacitor 54. If capacitor 54 is low then transistors 45, 48 and 51 are turned off and transistors 50 and 52 are on pulling down the output line 24 and if it is high transistors 48 and 51 are turned on and transistors 50 and 52 are turned off pushing up the output line 24.

If, however, the device is to be used in a double clock mode the node 18 is brought up and since the node 17 is normally high current is drawn through devices 31 and 32 pulling the gates of transistors 30, 37, and 40 low and turning these devices off. When device 40 turns off the line 26 coupled to the source of device 40 rises turning on transistor 38 and pulling line 25 low. When line 26 rises the transistor 47 turns on. A positive signal now appearing at the gate of transistor 48 will cause the node 56 to be pulled low shutting off transistors 50 and 52 causing line 24 to rise. Similarly, if the gate of transistor 48 is held low by the capacitor 54 then transistors 49 and 51 are off and node 56 remains high holding on transistors 50 and 52 causing line 24 to be pulled towards ground.

It should be particularly noted that device 41 through 52 in particular comprise a programmable latching circuit having a pair of cross coupled circuits comprising two programmable legs and a third non-programmable leg such that the first programmable leg is selected by a signal and the other programmable is selected by the complementary of the signal.

Thus, there has been described a circuit which during operation can have selected data inputs and require only a single clock to capture and hold the data, but during the test must act as a shift register latch in order to prevent a race condition that requires two clocks to scan data into and out of the scan rings formed by the registers.

While the invention has been particularly described with reference to the preferred embodiments thereof it will be understood by those skilled in the art that changes in form and details can be made in the foregoing preferred embodiments. For example, one skilled in the art could readily implement the invention in a bipolar transistor configuration.

**Claims**

1. A programmable latching circuit with optional single or double clocking for operation and testing, respectively, comprising
an AND circuit (10) coupled to and driving a pair of serial NOT circuits (12, 13) and having a fixed input (18) and a first clock input (17),
each of said NOT circuits having an output (25, 26) coupled to and programming an AND/OR circuit (15),
a second clock input (19) and both data and scan inputs (20, 21) coupled to a multiplexer circuit (14) coupled to and feeding said scan or data inputs to said AND/OR circuit (15),
a NOR circuit (11) coupled to and controlling said multiplexer circuit (14), said second clock input (19) and said fixed input (18) being coupled to and driving said NOR circuit and

a push-pull (16) circuit coupled to the output of said AND/OR circuit (15) to provide an output indicative of the state of said multiplexer circuit.

2. The circuit of claim 1 wherein said multiplexer circuit (15) comprises an input transistor (41, 42) driven by a clock and coupled to an input node, a capacitive node (54) and a switching transistor (43), said AND/OR (15) circuit comprises a pair of parallel programmable transistors (44, 47), each of which is coupled to a load transistor (46) and to ground through a respective gating transistor (45, 48),
one of said gating transistors having its control electrode coupled to said capacitive node (54) and the other said gating transistor (48) having its control electrode coupled to said switching transistor (43), and
said push-pull circuit (16) comprises a load transistor (49) coupled to ground through a source follower transistor (50), the control electrode of said load transistor is coupled to the switching transistor (43) and the control electrode of said other gating transistor (48), a push transistor (51) coupled between a voltage source (53) and an output line (24) and a pull transistor (52) coupled between said output line and ground.

3. The logic circuit of claims 1 or 2 wherein said AND circuit (10) comprises a first input transistor (31), having its control electrode coupled to said fixed input (18), in series, between a voltage source and ground, with a second input transistor (32), having its control electrode coupled to said first clock signal, and a load transistor (30),
said first NOT circuit (12), coupled to the AND circuit (10), comprising a load transistor (39) in series with a switching transistor (40) and coupled between said voltage source and ground, the output of said NOT circuit being coupled to the switching transistor (38) of the second NOT circuit and to the first programming transistor 7) in said AND/OR circuit (15),
said second NOT circuit (13) in series with said first NOT circuit and comprising a load transistor (37) in series with a switching transistor (38), the output of the second NOT circuit being coupled to the control electrode of the second programming transistor (44) or the AND/OR circuit (15) and the NOR (11) circuit comprising a load transistor (33) and a plurality of parallel decode transistors (34 to 36), said load transistor and each decode transistor being in series between said voltage source and ground, the output (line 22) of said NOR circuit being coupled to the control electrode of the switching transistor (43) in said multiplexer circuit (14).

4. The circuit of one of the preceding claims wherein there are formed first and second programmable circuit legs (44, 45; 47. 48) and a third nonprogrammable leg (49, 50), said first programmable leg (47, 48) cross coupled to said third leg (49, 50), and said second programmable leg (44, 45) being switchably cross coupled to said third leg.

5. The circuit of claim 4 wherein said first programmable leg (47, 48) is programmed by a selected input signal (line 26) and said second programmable leg is programmed by the complementary (line 25) of said selected input signal.

6. The circuit of one of the preceding claims wherein there is further provided in said latch, means (21, 27, 42) for coupling a data value to said second programmable leg (44, 45) and means for coupling push-pull output to said first programmable leg (47, 48).

7. The circuit of one of the preceding claims wherein said first programmable leg comprises a first load transistor (46) coupled in series with a first programmable transistor (47) and a first gating transistor (48), and between a voltage source and ground, said second programmable leg comprising a second programmable transistor (44) in series with a second gating transistor (45) and coupled between said load transistor (46) and ground, said third leg comprises a second load transistor (49) in series with a switching transistor (50) and coupled between said voltage source and ground the control electrode of the switching transistor (50) being coupled at the junction (56) between said first load transistor (46) and said first and second programming transistor (47, 44), and the junction between said second load transistor (49) and said switching transistor (50) being switchably coupled to the gate of said second gating transistor (48).

8. The circuit of one of the preceding claims wherein there is further provided a push-pull output stage coupled to said third leg (49, 50) and comprising a push transistor (51) having its control electrode coupled in common with said second load transistor (49) and the control electrode of said first gating transistor (48) and coupled between said voltage source and an output line (24), and a pull transistor (52) having its control electrode coupled in common with the control electrode of the switching transistor (50) and coupled between said output line and ground.

9. The circuit of one of the preceding claims wherein there is further provided a capacitive storage means (54) coupled to the control electrode of said second gating transistor (45).

10. The circuit of one of the preceding claims wherein there is further provided a switchable input transistor (42) coupled between data input means (21, 27) and the gate of said second gating transistor (45).

**Patentansprüche**

1. Programmierbare, wahlweise einfach oder doppelt getaktete Verriegelungsschaltung für Betrieb bzw. Test, folgendes umfassend:

Eine UND-Schaltung (10), welche mit zwei seriellen NICHT-Schaltungen (12, 13) verbunden ist und diese einstellt sowie einen festen Eingang (18) und einen ersten Takteingang (17) aufweist,

wobei jede der NICHT-Schaltungen einen Ausgang (25, 26) enthält, welcher mit einer UND/ODER-Schaltung (15) gekoppelt ist und diese einstellt,

einen zweiten Takteingang (19) und sowohl Datenwie auch Abtasteingänge (20, 21) gekoppelt mit einer Multiplexorschaltung (14), welche mit den Abtast- oder Dateneingängen zur UND/ODER-Schaltung (15) verbunden ist und diese beaufschlagt,

eine NOR-Schaltung (11), die mit der Multiplexorschaltung (14) verbunden ist und diese steuert, wobei der zweite Takteingang (19) und der feste Eingang (18) mit der NOR-Schaltung verbunden sind und diese beaufschlagen, sowie

eine Gegentaktschaltung (16), welche mit dem Ausgang der UND/ODER-Schaltung (15) gekoppelt ist, um einen den Status der Multiplexorschaltung anzeigenden Ausgang vorzusehen.

2. Schaltung nach Anspruch 1, worin die Multiplexorschaltung (15) einen taktgetriebenen, mit einem Eingangsknotenpunkt verbundenen Eingangstransistor (41, 42), einen kapazitiven Knotenpunkt (54) sowie einen Schalttransistor (43) umfaßt,

und worin die UND/ODER-Schaltung (15) zwei parallele programmierbare Transistoren (44, 47) enthält, von denen jeder mit einem Lasttransistor (46) und durch einen entsprechenden Steuer-Transistor (45, 48) mit Masse verbunden ist,

wobei die Steuerelektrode des einen Steuer-Transistors mit dem kapazitiven Knotenpunkt (54) und die Steuerelektrode des anderen Steuer-Transistors (48) mit dem Schalttransistor (43) verbunden sind, und

worin die Gegentaktschaltung (16) einen durch einen Sourcefolger-Transistor (50) mit Masse verbundenen Lasttransistor (49) enthält, und worin die Steuerelektrode des Lasttransistors mit dem Schalttransistor (43) und der Steuerelektrode des anderen Steuer- Transistors (48) verbunden ist, und worin ein Push- Transistor (51) zwischen einer Spannungsquelle (53) und einer Ausgangsleitung (24) geschaltet und ein Pull-Transistor (52) zwischen der Ausgangsleitung und Masse geschaltet sind.

3. Logische Schaltung der Ansprüche 1 oder 2, worin die UND-Schaltung (10) einen ersten Eingangstransistor (31) enthält, dessen Steuerelektrode mit dem festen Eingang (18) in Serie zwischen einer Spannungsquelle und Masse geschaltet ist, sowie einen zweiten Eingangstransistor (32), dessen Steuerelektrode mit dem ersten Taktsignal gekoppelt ist, sowie mit einem Lasttransistor (30), wobei die erste, mit der UND-Schaltung (10) gekoppelte NICHT-Schaltung (12) einen Lasttransistor (39) in Serie mit einem Schalttransistor (40) zwischen der Spannungsquelle und Masse enthält, wobei der Ausgang der NICHT-Schaltung mit dem Schalttransistor (38) der zweiten NICHT-Schaltung und mit dem ersten Programmierungstransistor (47) in der UND/ODER-Schaltung (15) verbunden ist,

und wobei die zweite NICHT-Schaltung (13) in Serie mit der ersten NICHT-Schaltung geschaltet ist und einen Lasttransistor (37) in Serie mit einem Schalttransistor (38) aufweist, wobei der Ausgang der zweiten NICHT-Schaltung mit der Steuerelektrode des zweiten Programmierungstransistors (44) oder der UND/ODER-Schaltung (15) verbunden ist, und

wobei die NOR-Schaltung (11) einen Lasttransistor (33) und mehrere parallele Dekodier-Transistoren (34 bis 36) aufweist, wobei der Lasttransistor und jeder Dekodier-Transistor in Serie zwischen der Spannungsquelle und Masse vorgesehen ist, und wobei der Ausgang (Leitung 22) der NOR-Schaltung mit der Steuerelektrode des Schalttransistors (43) in der Multiplexorschaltung (14) geschaltet ist.

4. Schaltung nach einem der vorhergehenden Ansprüche, mit ersten und zweiten programmierbaren Schaltungsteilen (44, 45; 47, 48) und einem nicht programmierbaren Teil (49, 50),

wobei der erste programmierbare Teil (47, 48) mit dem dritten Teil (49, 50) kreuzgekoppelt ist, und wobei der zweite programmierbare Teil (44, 45) schaltbar mit dem dritten Teil kreuzgekoppelt ist.

5. Schaltung nach Anspruch 4, worin der erste programmierbare Teil. (47, 48) durch ein ausgewähltes Eingangssignal (26) und der zweite programmierbare Teil durch das komplementäre Signal (Leitung 25) des ausgewählten Eingangssignals programmiert. wird.

6. Schaltung nach einem der vorhergehenden Ansprüche, worin die Verriegelungsschaltung außerdem Mittel (21, 27, 42) zum Anlegen eines Datenwerts an den zweiten programmierbaren Teil (44, 45) enthält sowie Mittel zum Verbinden des Gegentaktausgangs mit dem ersten programmierbaren Teil (47, 48).

7. Schaltung nach einem der vorhergehenden Ansprüche, worin der programmierbare Teil einen ersten Lasttransistor (46) enthält, welcher zwischen einer Spannungsquelle und Masse in Serie mit einem ersten programmierbaren Transistor (47) und einem ersten Steuer-Transistor (48) verbunden ist,

wobei der zweite programmierbare Teil einen zweiten programmierbaren Transistor (44) in Serie mit einem zweiten Steuer-Transistor (45) zwischen dem Lasttransistor (46) und Masse enthält,

und wobei der dritte Teil einen zweiten Lasttransistor (49) in Serie mit einem Schalttransistor (50) zwischen der Spannungsquelle und Masse enthält, und wobei die Steuerelektrode des Schalttransistors (50) mit dem Verbindungspunkt (56) zwischen dem ersten Lasttransistor' (46) und dem ersten und zweiten Programmiertransistor (47, 44) verbunden ist und wobei der Verbindungspunkt zwischen dem zweiten Lasttransistor (49) und dem Schalttransistor (50) schaltbar mit dem Gate des zweiten Steuer-Transistor (48) verbunden ist.

8. Schaltung nach einem der vorhergehenden Ansprüche, welche außerdem einen Gegentaktausgang enthält, welcher mit dem dritten Teil (49, 50) verbunden ist und einen Push-Transistor (51) aufweist, dessen Steuerelektrode gemeinsam mit dem zweiten Lasttransistor (49) und der Steuerelektrode des ersten Steuer-Transistor (48) zwischen der Spannungsquelle

und einer Ausgangsleitung (24) geschaltet ist, und

mit einem Pull-Transistor (52), dessen Steuerelektrode gemeinsam mit der Steuerelektrode des Schalttransistors (50) zwischen der Ausgangsleitung und Masse geschaltet ist.

9. Schaltung nach einem der, vorgehenden Ansprüche, welche weiterhin einen kapazitiven Speicher (54) enthält, der mit der Steuerelektrode des zweiten Steuer-Transistor (45) verbunden ist.

10. Schaltung nach einem der vorhergehenden Ansprüche, welche weiterhin einen schaltbaren Eingangstransistor (42) zwischen Dateneingabemitteln (21, 27) und dem Gate des zweiten Steuer-Transistor (45) enthält.

**Revendications**

1. Circuit de verrouillage programmable avec une synchronisation simple ou double optionnelle pour le fonctionnement et la vérification, respectivement, comportant

un circuit ET (10) couplé à et attaquant une paire de circuits NON série (12, 13) et ayant une entrée fixe (18) et une première entrée d'horloge (17),

chacun desdits circuits NON ayant une sortie (25, 26) couplée à et programmant un circuit ET/OU (15).

une deuxième entrée d'horloge (19) et des entrées de données et d'analyse (20, 21) couplées à un circuit multiplexeur (14) couplé audit circuit ET/OU (15) et lui délivrant lesdites entrées de données ou d'analyse,

un circuit NON-OU (11) couplé audit circuit multiplexeur (14) et le commandant, ladite deuxième entrée d'horloge (19) et ladite entrée fixe (18) étant couplées audit circuit NON-OU et l'attaquant, et

un circuit push-pull (16) couplé à la sortie dudit circuit ET/OU (15) afin de délivrer une sortie indicative de l'état dudit circuit multiplexeur.

2. Circuit de la revendication 1 dans lequel ledit circuit multiplexeur (15) comporte un transistor d'entrée (41, 42) attaqué par une horloge et couplé à un noeud d'entrée, un noeud capacitif (54) et un transistor de commutation (43),

ledit circuit ET/OU (15) comporte une paire de transistors programmables parallèles (44, 47), chacun d'entre eux étant couplé à un transistor de charge (46) et à la masse par l'intermédiaire d'un transistor de déclenchement respectif (45, 48),

l'un desdits transistors de déclenchement ayant son électrode de commande couplée audit noeud capacitif (54) et l'autre desdits transistors de déclenchement (48) ayant son électrode de commande couplée audit transistor de commutation (43), et

ledit circuit push-pull (16) comporte un transistor de charge (49 couplé à la masse par l'intermédiaire d'un transistor à source chargée (50), l'électrode de commande dudit transistor de charge étant couplée au transistor de commutation (43) et à l'électrode de commande dudit autre transistor de déclenchement (48), un transistor "push" (51) couplé entre une source de tension (53) et une ligne de sortie (24) et un transistor "pull" (52) couplé entre ladite ligne de sortie et la masse.

3. Circuit logique des revendications 1 ou 2 dans lequel ledit circuit ET (10) comporte un premier transistor d'entrée (31), ayant son électrode de commande couplée à ladite entrée fixe (18), en série, entre une source de tension et la masse, avec un deuxième transistor d'entrée (32), ayant son électrode de commande couplée audit premier signal d'horloge, et un transistor de charge (30),

ledit premier circuit NON (12), couplé au circuit ET (10), comportant un transistor de charge (39) en série avec un transistor de commutation (40) et couplé entre ladite source de tension et la masse, la sortie dudit circuit NON étant couplée au transistor de commutation (38) du deuxième circuit NON et au premier transistor de programmation (47) dans ledit circuit ET/OU (15),

ledit deuxième circuit NON (13) étant en série avec ledit premier circuit NON et comportant un transistor de charge (37) en série avec un transistor de commutation (38), la sortie du deuxième circuit NON étant couplée à l'électrode de commande du deuxième transistor de programmation (44) du circuit ET/OU (15) et

le circuit NON-OU (11) comportant un transistor de charge (33) et une pluralité de transistors de décodage parallèles (34 à 36), ledit transistor de charge et chaque transistor de décodage étant en série entre ladite source de tension et la masse, la sortie (ligne 22) dudit circuit NON-OU étant couplée à l'électrode de commande du transistor de commutation (43) dans ledit circuit multiplexeur (14).

4. Circuit de l'une des revendications précédents dans lequel sont formées des première et deuxième branches de circuit programmables (44, 45; 47, 48) et une troisième branche non-programmable (49, 50),

ladite première branche programmable (47, 48) étant couplée en croix avec ladite troisième branche (49, 50), et

ladite deuxième branche programmable (44, 45) étant couplée en croix de façon commutable à ladite troisième branche.

5. Circuit de la revendication 4 dans lequel ladite première branche programmable (47, 48) est programmée par un signal d'entrée sélectionné (ligne 26) et ladite deuxième branche programmable est programmée par le complémentaire (ligne 25) dudit signal d'entrée sélectionné.

6. Circuit de l'une des revendications précédentes dans lequel sont de plus disposés, dans ledit verrou, des moyens (21, 27, 42) pour coupler une valeur de donnée à ladite deuxième branche programmable (44, 45) et des moyens pour coupler la sortie push-pull à ladite première branche programmable (47, 48).

7. Circuit de l'une des revendications précédentes dans lequel ladite première branche programmable comporte un premier transistor de charge (46) couplé en série avec un premier transistor programmable (47) et un premier transistor de déclenchement (48), et entre une source de tension et la masse,

ladite deuxième branche programmable comporte un deuxième transistor programmable (44) en série avec un deuxième transistor de déclenchement (45) et couplé entre ledit transistor de charge (46) et la masse,

ladite troisième branche comporte un deuxième transistor de charge (49) en série avec un transistor de commutation (50) et couplé entre ladite source de tension et la masse,

l'électrode de commande du transistor de commutation (50) étant couplée à la jonction (56) entre ledit premier transistor de charge (46) et lesdits premier et deuxième transistors de programmation (47, 44), et

la jonction entre ledit deuxième transistor de charge (49) et ledit transistor de commutation (50) étant couplée de façon commutable à la grille dudit deuxième transistor de déclenchement (48).

8. Circuit de l'une des revendications précédentes dans lequel est de plus disposé un étage de sortie push-pull couplé à ladite troisième branche (49, 50) et comportant un transistor "push" (51) ayant son électrode de commande couplée en commun avec ledit deuxième transistor de charge (49) et avec l'électrode de commande dudit premier transistor de déclenchement (48) et couplé entre ladite source de tension et une ligne de sortie (24), et un transistor "pull" (52) ayant son électrode de commande couplée en commun avec l'électrode de commande du transistor de commutation (50) et couplé entre ladite ligne de sortie et la masse.

9. Circuit de l'une des revendications précédentes dans lequel sont de plus disposés des moyens de mémorisation capacitifs (54) couplés à l'électrode de commande dudit deuxième transistor de déclenchement (45).

10. Circuit de l'une des revendications précédentes dans lequel est de plus disposé un transistor d'entrée commutable (42) couplé entre des moyens d'entrée de données (21, 27) et la grille dudit deuxième transistor de déclenchement (45).

FIG. 1

0 137 165

1

FIG. 2